Europäisches Patentamt

(19) European Patent Office

Office européen des brevets

(11) Publication number: **0 043 929**
**B1**

(12) **EUROPEAN PATENT SPECIFICATION**

(45) Date of publication of patent specification: **27.12.85**

(51) Int. Cl.⁴: **H 04 B 9/00, H 01 L 31/12**

(21) Application number: **81104609.3**

(22) Date of filing: **15.06.81**

(54) Fibre optical measuring device.

(30) Priority: **23.06.80 SE 8004602**

(43) Date of publication of application:
**20.01.82 Bulletin 82/03**

(45) Publication of the grant of the patent:
**27.12.85 Bulletin 85/52**

(84) Designated Contracting States:
**CH DE FR GB IT LI**

(56) References cited:
**DE-A-1 489 503**
**DE-A-2 924 581**
**US-A-4 176 367**
**US-A-4 179 702**

**THE BELL SYSTEM TECHNICAL JOURNAL, vol.
58, no. 7, September 1979, pages 1735-1741,
New York (USA); R.C. MILLER et al.: "Optically
powered speech communication over a fiber
lightguide".**

(73) Proprietor: **ASEA AB**
**S-721 83 Västeras (SE)**

(72) Inventor: **Adolfsson, Morgan**
**S. Edströms gata 86**
**S-724 66 Västeräs (SE)**
Inventor: **Brogärdh, Torgny**
**Plätverksgatan 140**
**S-724 74 Västeräs (SE)**
Inventor: **Ovren, Christer**
**Vilddjursvägen 9**
**S-722 43 Västeräs (SE)**

(74) Representative: **Boecker, Joachim, Dr.-Ing.**
**Rathenauplatz 2-8**
**D-6000 Frankfurt a.M. 1 (DE)**

## Description

The invention relates to a fibre optical measuring device according to the prior art portion of claim 1. Such a measuring device is known from DE—A—2 924 581.

In an optically supplied electronic system or when using optically coupled measuring transducers which require some form of excitation energy, power has to be transmitted in one direction and signal information in the opposite direction.

The fibre optical measuring device according to the abovementioned application comprises a transducer section which comprises optically supplied electronic equipment, the supply power and the measuring signal being arranged to be transmitted on the same light guide fibre. The device further includes light-emitting diodes (LEDs) and photodiodes. The one or more light-emitting diode(s) for transmitting a measuring signal is/are transparent to light with the wavelength λ which is used for supplying the photo-diode for the power supply. These light-emitting diodes are located in the optical path between the fibre end and the one or more photo-diode(s) receiving the optical supply power. The photo-diode(s) for receiving the measuring signals is/are transparent to light with the wavelength λ which is used for the supply, and these photo-diodes are located between the fibre end and the light-emitting diode(s) which deliver(s) the supply power.

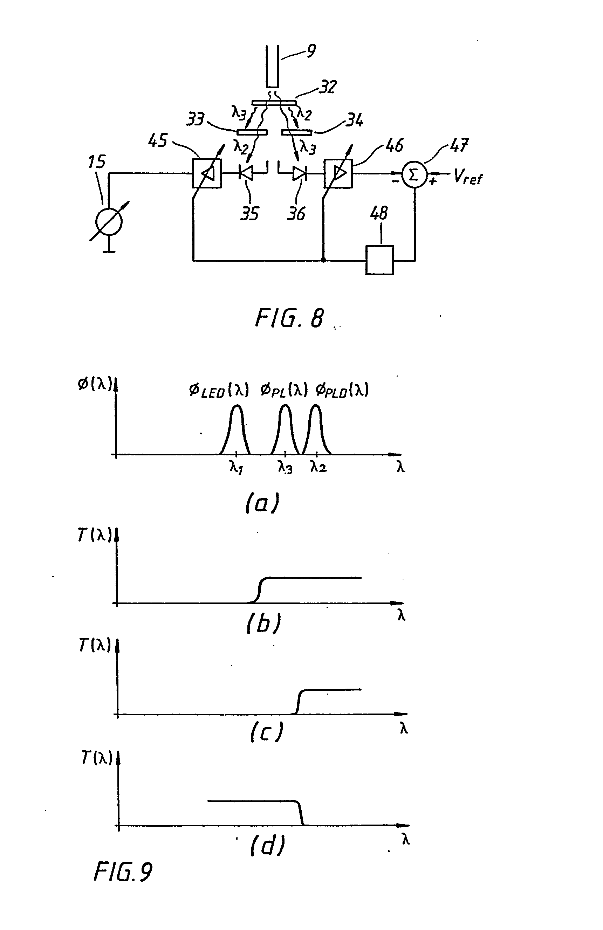

DE—A—2 924 581 discloses in Figure 8 a telecommunication device with a photo-luminescence diode in a first section which is connected through a single light guide fibre with a second section capable of receiving information signals through light with a first wavelength and transmitting information signals through light with a second wavelength. The entire energy required in said first section (transducer section) is delivered by a direct component of said light with the first wavelength. Said diode has a time-sharing mode of operation, i.d. the diode works during one period as a photo diode and during another period as a light emitting diode. The transducer section requires an energy storage to store the energy received during said first period and required during said second period. The transducer section of this telecommunication device includes a direct voltage converter which amplifies the direct voltage component from the diode and supplies it to a separate direct current bus. During the light emitting period the current for said photo-luminescence diode is supplied from said energy storage through a converter where the current is modulated with the signal to be transmitted.

The invention aims at developing an improved fibre optical transmission device of the above-mentioned kind, which allows receiving energy light and transmitting signals permanently at the same time at any one time and being built up of simple components without the need of an energy storage for the supply of the photo-luminescence device.

In order to achieve these aims the invention suggests a fibre optical measuring device of the above-mentioned kind, which is characterized by the features of the characterizing portion of claim 1.

Alternative embodiments of the invention are characterized by the feature of the further claims.

The invention also relates to a device for carrying out a method of using a component, designated "photo-luminescence diode", which is at the same time a photo-diode and a light-emitting diode. An improved efficiency is obtained since charge carriers, which are excited by light, recombine directly and emit the information-carrying light. The device is based on the fact that there is a concentration of optically excited minority charge carriers in the active region of an illuminated diode. There is a certain probability that the minority charge carriers will recombine with radiating recombination, which results in light being emitted.

The process described above is called photo-luminescence, and the intensity of the light which is emitted is a function of the concentration of minority charge carriers in a semiconductor material. This concentation can be controlled externally by controlling the amount of charge carriers which are tapped from the active region. This can be done by changing the current-voltage operating point of the diode, for example by changing the current output from the diode. The semiconductor material can consist of $Al_x Ga_{1-x}As$, where x assumes values between 0 and 1. The layer of the structure where the recombination takes places can be doped with Ge, or Si, or Zn, or Mg, or Cd. An alternative choice for said semiconductor material is $In_x Ga_{1-x}As_y P_{1-y}$, x and y assuming values between 0 and 1 and being adapted such that the lattice constants for the measured value in the different layers are as equal as possible.

The invention will be exemplified in greater detail with reference to the accompanying drawings, in which:

Figure 1 shows a circuit diagram of one embodiment of a device according to the invention,

Figure 2 shows the spectrum from the light-emitting diode,

Figure 3 shows one way of realizing a photo-luminescence diode,

Figures 4 and 5 show the function of the photo-luminescence diode,

Figure 6 shows a measuring device according to the invention where the photo-luminescence diode is used together with a transducer element,

Figure 7 shows an analog measuring device according to the invention,

Figure 8 shows the reception of signals and the signal processing,

Figure 9 shows emission spectra for the excitation light-emitting diode, the photo- luminescence diode and the photo-luminescence material,

Figure 10 shows material structure and light in case of intensity distribution,

Figure 11 finally shows a band diagram for the components according to Figure 10a.

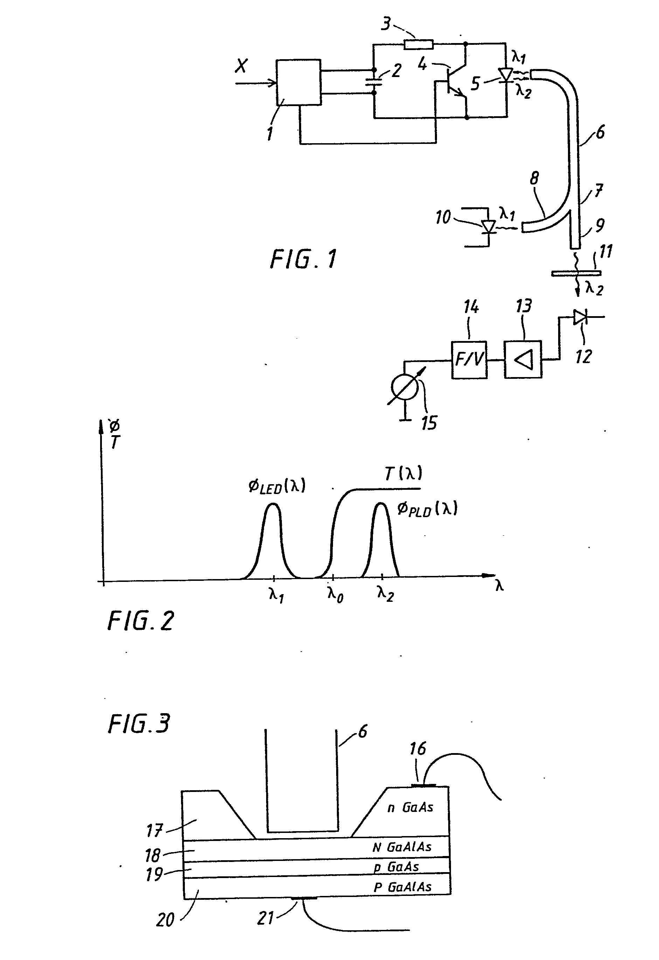

Figure 1 shows the use of a photo-luminescence diode in an optically fed measuring device according to the invention. A light-emitting diode 10 feeds light of the wavelength $\lambda_1$ into a light guide fibre 8. The light passes a fibre branch 7 and a fibre 6 and illuminates a photo-luminescence diode 5. Diode 5 supplies power to an electronic circuit 1 via a filter consisting of a resistor 3 and a capacitor 2. The electronic circuit 1 transforms a quantity to be measured—here designated as x and being the quantity to be measured by the device according to the invention—into coded form, for example a frequency, and controls a transistor 4 which modulates the current output from the photo-luminescence diode 5. Since the supply of the electronic circuit 1 takes place via a filter, the modulation is prevented from influencing the supply voltage. The modulation of the current outlet from photo-luminescence diode 5 also causes the photo-luminescence from 5 to become modulated. The luminescence has the wavelength $\lambda_2$ and is transmitted via the light guide fibre 6, the branch 7, a fibre 9 and a filter 11 to a photo-diode 12. The task of the filter 11 is to filter away any reflected light with the wavelength $\lambda_1$. The output current from the photo-diode 12 constitutes an illustration of the modulation of the photo-luminescence diode 5. After amplifying the photo-current by an amplifier 13, the measuring signal is decoded in an electronic circuit 14, shown in Figure 1 as a frequency/voltage convertor. The output signal from circuit 14 gives the measured value of quantity x on a measuring instrument 15.

Figure 2 shows the spectrum from the light-emitting diode 10 designated $\phi_{LED}(\lambda)$, the transmission curve for the Filter 11 designated $T(\lambda)$, and the spectrum from the photo-luminescence diode, designated $\phi_{PLD}(\lambda)$.

Figure 3 shows a device with a photo-luminescence diode of GaAs/GaAlAs. On a substrate 17 of GaAs there are formed in successive order by liquid phase epitaxy an N-layer 18 of GaAlAs, a p-doped GaAs layer 19 and a P-doped GaAlAs layer 20. Through the substrate 17 there is etched a hole, through which the fibre may be inserted. The Al content in layer 18 is so high that the transmission at the excitation wavelength $\lambda_1$ is high. When the structure is illuminated by light of the wavelength $\lambda_1$, the main part of the absorption and thus the generation of the minority charge carriers takes place in the active GaAs layer 19. The active layer 19 is limited partly by the pN-heterojunction (two semiconductor materials having different band gaps) between layers 18 and 19, and partly by the pP-junction to layer 20. Because layer 20 is made of a material having a higher band gap, minority charge carriers are prevented from penetrating into layer 20. The photo-luminescence diode is contacted with metallized portions 16 and 21.

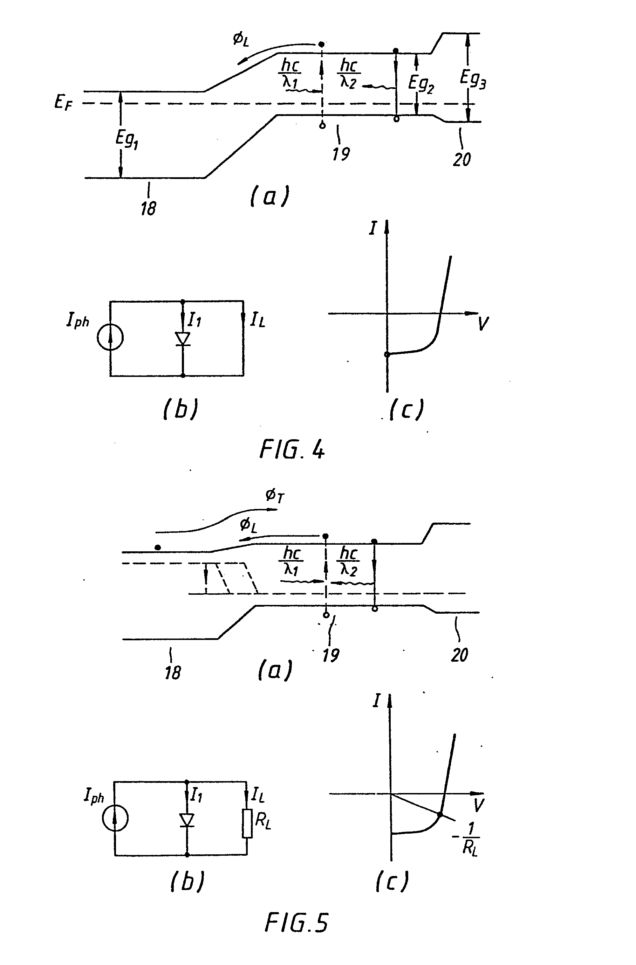

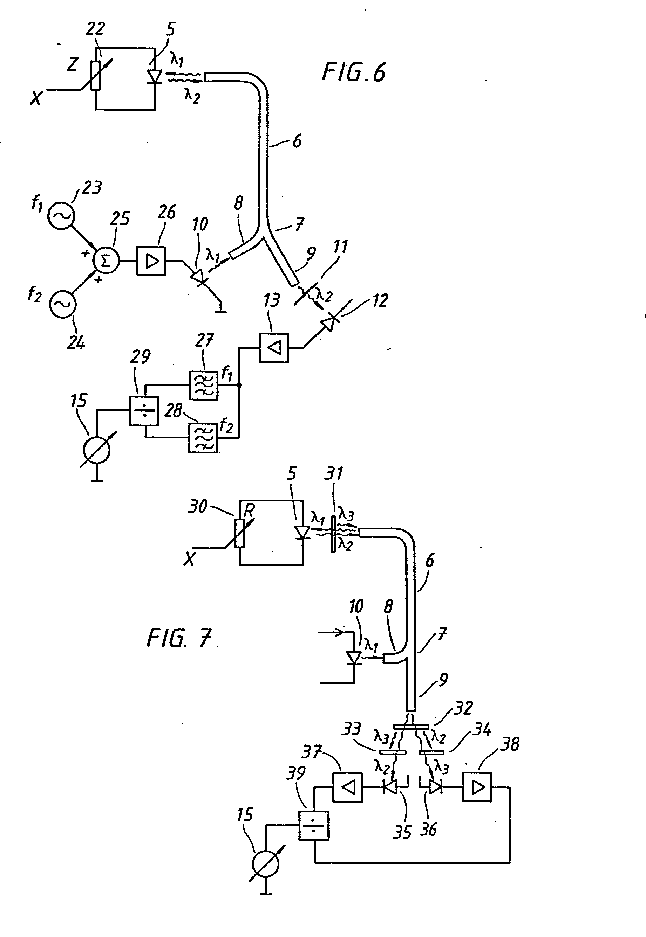

The function of the photo-luminescence diode will be further explained in connection with Figures 4 and 5, where a is a band diagram, b is an equivalent circuit diagram, and c denotes the working point in a current/voltage diagram. Figure 4 shows a short-circuited photo-luminescence diode, and Figure 5 shows a diode loaded with a resistance $R_L$. The band diagram in Figure 4a shows the active layer 19 surrounded by two layers having greater band gaps, 18 and 20. Because the diode is short-circuited, there is no voltage across the pN-junction and therefore the Fermi level is constant through the structure. If the diode is illuminated by light of the wavelength $\lambda_1$, where

$$E_{g1} > \frac{hc}{\lambda_1} > E_{g2}$$

($E_{g1}$ being the band gap in layers 18 and $E_{g2}$ the band gap in layer 19), the light has a high transmission through the layer 18, and the main part of the light is absorbed in the layer 19, which leads to the formation of minority charge carriers, in this case electrons. The electrons are prevented from penetrating into region 20 by the potential barrier which is caused by the band gap $E_{g3}$ in layer 20 being greater than the band gap $E_{g2}$. The addition of optically excited electrons in the active region 19 is balanced by two processes. Electrons are passed across the pN-junction between regions 19 and 18, which gives rise to an electron flux $\phi_L$ from region 19, which gives the short-circuit current of the diode. In addition, electrons in region 19, have a certain probability to recombine with holes. Part of this recombination is radiating, which results in photons with the energy $hc/\lambda_2$ being emitted. The intensity of the emitted radiation depends on the concentration of the minority charge carriers in region 19.

Figure 4b shows an equivalent diagram for a short-circuited photo-luminescence diode, where the diode is represented by a current source, which provides the short-circuit current $I_{ph}$, caused by optical excitation, in parallel with an ideal diode. Upon a short-circuit, the entire optically excited current $I_{ph}$ passes through the external short-circuit, the current through the ideal diode being zero.

Figure 4c shows the current/voltage characteristic of the photo-luminescence diode. The working point for a short-circuited diode is marked by a ring in Figure 4c.

The band diagram of a photo-luminescence diode with a load resistance $R_L$ coupled across its connections is shown in Figure 5a. Compared with the band diagram in Figure 4a, Figure 5a differes in that a voltage is applied across the diode. The voltage is caused by the current which passes through the load resistance $R_L$. Because the voltage V across the diode is not zero, the Fermi level varies through the diode, and the potential barrier in the pN-junction is much lower than in the case with a short-circuited diode. The low potential barrier makes it possible for majority charge carriers, electrons in region 18, to penetrate into region 19. The electrons give an electron flux $\phi_T$, which is opposite to the flux $\phi_L$ caused by the optically excited electron surplus in 19. The electron concentration in region 19 will thus be higher than with a short-circuited diode. This leads to a higher intensity of the light from a radiating recombination in region 19. ·In the borderline case of an open circuit $(R_L \to \infty)$, the electron fluxes $\phi_L$ and $\phi_T$ will cancel each other, and therefore all electrons which are formed by optical excitation will disappear through recombination in the active region 19, and the intensity of the radiating recombination is high. The internal quantum efficiency is determined by the number of electrons which recombine while emitting light, and the number of electrons which recombine via other processes, for example via defects in region 19 or in its limiting surfaces.

An equivalent circuit diagram of the photo-luminescence diode, coupled to a load resistance $R_L$, is shown in Figure 5b. The current $I_{ph}$ is divided between the ideal diode and the load resistance.

Figure 5c shows the current/voltage characteristic of the photo-luminescence diode together with the load line of the resistance $R_L$. The intersection between the curves defines the operating point of the circuit. By modulating the resistance $R_L$, the current from the photo-luminescence diode can be modulated. If the photo-luminescence diode is made such that the thickness of the active region 19 is smaller than the diffusion length $L_n$ (material parameter determined by the purity and quality of the material) in the active region, the concentration of minority charge carriers and thus the luminescence from the photo-luminescence diode will be modulated at the same rate as $R_L$.

Figure 6 shows a measuring device where the photo-luminescence diode 5 is used together with a transducer element 22, the frequency dependence of which is influenced by the quantity X to be measured. The transducer element may be inductive or capacitive and may also contain a resistive component. The quantity to be measured may influence the inductance, the capacitance and/or the resistance of the impedance Z. The mode of operation of the measuring device is as follows:

Two oscillators 23 and 24 deliver signals of different frequencies $f_1$ and $f_2$, respectively. These signals are added in a summation circuit 25, the output signal of which controls a drive circuit 26, which supplies current through a light-emitting diode 10. The output light from the light-emitting diode 10 has the wavelength $\lambda_1$. It passes through a fibre 8, a fibre branch 7, and a fibre 6, at the end of which it illuminates the photo-luminescence diode 5. This diode 5 is connected across an impedance Z, which constitutes the transducer element 22. The frequency dependence of the impedance is influenced by the quantity X being measured, and therefore the current through the diode 5 will be frequency-dependent and influenced by the quantity being measured. The light emission from the photo-luminescence diode 5 is dependent on the current through said diode and will therefore be frequency-dependent and influenced by the quantity to be measured. The output light from the diode 5 has the wavelength $\lambda_2$ and is transmitted via the fibre 6, the fibre branch 7, a light guide fibre 9 and a filter 11 to a photodiode 12. The task of the filter 11 is to filter away any components of the excitation light with the wavelength $\lambda_1$. The current from the photo-diode 12 is amplified in an amplifier 13, the output signal of which is divided into the components with the frequencies $f_1$ and $f_2$, respectively, by means of the band pass filters 27 and 28, respectively. The quotient between the output signals from the filters is formed in a dividing circuit 29, the output signal of which gives the measuring signal X to the instrument 15.

By utilizing two frequencies $f_1$ and $f_2$, two independent variables can be transmitted, one being the measured value and the other being variations in the optical transmission, which can then be eliminated by division.

The transducer element may consist of one or more components, the frequency properties of which are changed by the quantity to be measured. The frequency properties are arranged to be analyzed by measuring with several frequencies, measuring of phase shift, time delay and/or time constant to extract the measuring signal and compensate for variations in the optical transmission.

The photo-luminescence diode in combination with resistive transducer elements can be used for direct analog measurements. Piezo-resistive materials, thermistors or magneto-diodes can operate as transducer elements. In such a system compensation must take place for variations of the transmission parameters of the optical system. Figure 7 shows an analog measuring system, where the photo-luminescence from the material of a layer 31 in the figure functions as a reference signal and provides a possibility of compensating for variations of the transmission parameters of the optical system. Current is driven through a light-emitting diode 10, the emitted light of which with the wavelength $\lambda_1$ is transmitted via a light guide fibre 8, a fibre branch 7, and a fibre 6 to a photo-luminescence diode 5. Simultaneously with the photo-luminescence diode 5, there is also illuminated a layer 31 of a material which emits photo-luminescence of the wavelength $\lambda_3 \neq \lambda_2$. $\lambda_2$ is the wavelength of the emitted light of the photo-luminescence diode 5. The photo-luminescence diode 5 is connected across a resistive transducer element 30, the resistance of which is controlled by the quantity X to be measured. The current through and the light from the photo-luminescence diode 5 are thereby controlled by the quantity X to be measured.

Both, the luminescence signals of the wavelength $\lambda_2$ and the wavelength $\lambda_3$, respectively, are returned to the instrument side by the fibre 6, the fibre branch 7, and a light guide fibre 9. Any components of the excitation light with the wavelength $\lambda_1$ are eliminated in a filter 32. The light components of the wavelengths $\lambda_2$ and $\lambda_3$, respectively, are separated by means of two filters 33 and 34, each component then illuminating a photo-diode 35 and 36, respectively. The signals from the photo-diodes are amplified in the amplifiers 37 and 38, respectively. Then the quotient between the two signals is formed in a dividing circuit 39. In the dividing circuit 39 a signal proportional to the light from the photo-luminescence diode 5 is divided by a signal which is proportional to the reference signal. This reduces the dependence of the measured signal on the parameters of the optical transmission. The output signal from the circuit 39 gives the measured value X to the instrument 15. The "reference material" of the layer 31 can be a so-called up-converter.

Instead of forming the quotient, the transmitted reference signal may be used for controlling the amplification of an element in the transmission of the measuring signal. Figure 8 shows how the reception and the processing of the signal may be arranged in that case. The transmitted reference signal gives rise to a current in the photodiode 36, the current then being amplified in a variable amplifier 46, the output signal of which is passed to a summation circuit 47. In the circuit 47 the difference is formed between the signal from the amplifier 46 and a reference voltage $V_{ref}$. The difference signal is supplied to a regulator 48, the output signal of which controls the amplification in the variable amplifier 46 so that the difference signal from the circuit 47 becomes zero. The output signal from the regulator 48 also controls the amplification in the amplifier 45, where the transmitted measuring signal from the photo-diode is amplified before being supplied to the instrument 15. If the amplifiers 45 and 46 are identical, the transmission of the measuring signal will be constant, independent of variations of the parameters of the optical transmission.

Figure 9a shows the emission spectra for the excitation light-emitting diode 10, $\phi_{LED}(\lambda)$, photo-luminescence diode 5, $\phi_{PLD}(\lambda)$, and the photo-luminescence material of layer 31, $\phi_{PL}(\lambda)$. Figure 9b shows the transmission curve of the filter 32 in Figures 7 and 8. The filter has a high transmission for both the wavelengths $\lambda_2$ and $\lambda_3$, whereas light with the wavelength $\lambda_1$ is attenuated considerably. The transmission curve for the filter 33 is shown in Figure 9c. The transmission for $\lambda_2$ is high whereas light from the wavelength $\lambda_3$ is greately attenuated. Figure 9d shows that the transmission through the filter 34 is high at the wavelength $\lambda_3$, but low at $\lambda_2$. If the filter 34 is formed as a band pass filter around the wavelength $\lambda_3$, which attenuates $\lambda_1$ and $\lambda_2$, the filter 32 can be eliminated.

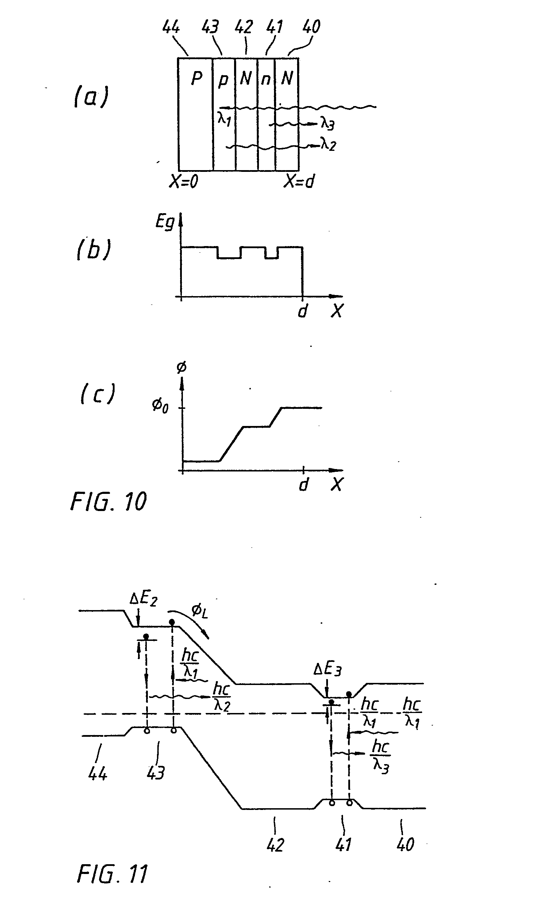

Figure 10a shows a structure where the photo-luminescence diode and the material which provides the reference signal, are located in the same component. Figure 10b shows the band gap for the material in the various layers. The distribution of the light intensity through the structure is shown in Figure 10c. Light which enters from the right is attenuated above all in the two layers with a small band gap, layers 41 and 43. The layers with a larger band gap 40, 42 and 44 have a high transmission for the excitation light of the wavelength $\lambda_3$. Since the layer 41 is surrounded by the layers 40 and 42 with larger band gap, minority charge carriers, holes, which are generated in the layer 41, will be contained and the efficiency in the photo-luminescence is high. The layer 41 shall be made so thin that only part of the excitation light is absorbed. The remaining light is absorbed for the major part in the layer 43, which constitutes the active region of the photo-luminescence. The emission from the layer 43 has the wavelength $\lambda_2 \neq \lambda_3$ and an intensity which can be controlled by the current through the photo-luminescence diode.

The band diagram for the component in Figure 10a with short-circuited photo-luminescence diode is shown in Figure 11. Light of the wavelength $\lambda_1$, which arrives from the right, passes the region 40 and generates minority charge carriers, holes, in the region 41. Some of these holes recombine with electrons, which results in photons of the wavelength $\lambda_3$ being emitted. The part of the light which is not absorbed in the region 41 passes the region 42 and is absorbed for the most part in the region 43, where minority-charge carriers, electrons, are formed. In the same way as has been described with reference to Figures 4 and 5, the electrons will sweep out via the pN-junction between the regions 43 and 42, or recombine in the region 43. Part of the recombination is radiant, light of the wavelength $\lambda_2$ then being emitted. The intensity of the emitted light is dependent on the concentration of the minority charge carriers in the region 43 and can therefore be controlled through the current taken from the diode. By making the region 41 of $Al_xGa_{1-x}As$ with an Al content smaller than the Al content in the regions 40, 42, 44, or by having recombinations in centres with different positions in the band gap for the regions 41 and 43, the wavelengths $\lambda_2$ and $\lambda_3$ may be caused to be different.

The photo-luminescence diode may, of course, be made with other barriers to control the concentration of minority charge carriers in the active region. In addition to hetero-pn-junction it may be made with homo-pn-junction, Schottky barrier, or MIS structure.

The recombination may be arranged to take place in a material with a monotonously decreasing band gap along the path of the excitation light. The material can then be provided with a barrier, a pn-junction, a Schottky or MIS structure, which results in a depletion layer the position of which is determined by the voltage across the barrier. If the excitation light has a wavelength which causes a considerable part of the excitation of charge carriers to take place within the distance of some diffusion length from the edge of the depletion layer, the spectral distribution of the emitted light will be dependent on the voltage across the barriers.

The photo-luminescence diode may be formed so that the active region on both sides are surrounded by controllable barriers, which will increase the possible degree of modulation for the luminescence by a factor four with a given thickness of the structure and a given diffusion length in the material.

Measuring devices, where the photo-luminescence diode is used for measuring a quantity other than the temperature, can also provide a measured value of the temperature by analyzing the spectrum of the photo-luminescence diode with methods previously proposed. (See GB patent application 8032550, published on June 3, 1981, published under No. 2 063 466). The temperature dependence of the measuring transducer may be adapted to be corrected by means of the measured value of the temperature.

The term "light", as used in the foregoing description, besides relating to light within the visible area also relates to electromagnetic radiation within UV- and IR-range.

The structure which provides the light for the signal transmission may be partially be transparent to the excitation light, so that several structures can be placed one after the other in a bus structure along the optical path. The different structures can emit light of the same or of different wavelength, thus enabling wavelength-multiplexed transmission of the measuring signals.

## Claims

1. Fibre optical measuring device with a transducer section (1—5) comprising an optically supplied electronic circuit (1) and/or transducer elements (22, 30) which require excitation energy, the supply power and the excitation energy being transmitted on the same light guide fibre as the signal information (measuring signal), whereby said signal information is arranged to be transmitted to a receiver location in the form of light which is emitted from the transducer section (1—5) when optically excited charge carriers recombine within the material of a photo-luminescence semiconductor device in the transducer section, and whereby this recombination is arranged to be controlled in accordance with the information signal to be emitted from the transducer section, characterized in that a variable impedance device (4, 22, 30) is connected directly and permanently across the semiconductor device (5), that the value of said impedance device varies according to the variations of the quantity to be measured, and that the variations of said impedance device modulate the light output of said semiconductor device accordingly.

2. Measuring device according to claim 1, characterized in that the recombination, which gives rise to the signal light, is dependent on the concentration of minority charge carriers in a semiconductor material, that the material is included in a pn-junction (5), e.g. a diode, where the band gap may be equal (homostructure) or different (hetero-structure) for the material on the p- and n-side, and that the concentration of minority charge carriers is arranged to be controlled by the current through, or the voltage across, the pn-junction (5).

3. Measuring device according to claim 1, characterized in that the recombination, which gives rise to the signal light, is dependent on the concentration of minority charge carriers in the semiconductor material, that the material is included in a Schottky diode or an MIS structure, and that the concentration on minority charge carriers is arranged to be controlled by the current through, or the voltage across, the Schottky diode or MIS structure (5).

4. Measuring device according to claim 1, characterized in that the recombination is arranged to take place in a material with a monotonously decreasing band gap along the path of the excitation light, that the material is provided with a barrier, a pn-junction, a Schottky or MIS structure, which provide a depletion layer, the position of which is determined by the voltage across said barrier, pn-junction, Schottky or MIS structure, and that the excitation light has a wavelength which causes a considerable part of the excitation of charge carriers to take place within the distance of some diffusion lengths from the edge of the depletion layer, the spectral distribution of the emitted light thus being dependent on the voltage across the barrier.

5. Measuring device according to claim 2 or 3, characterized in that the material (19) in which the light for the signal transmission is emitted is limited on one side by a material (18, 20) with a larger band gap, excited minority charge carriers thus being prevented from reaching semiconductor surfaces with a high recombination speed.

6. Measuring device according to claim 2 or 3, characterized in that the material, where the light for the signal transmission is emitted, is provided on both sides with barriers, pn-junctions, Schottky or MIS structures for modulating the concentration of charge carriers.

7. Measuring device according to any of the preceding claims, characterized in that part of the optically generated current through the barrier is adapted to be utilized for supply of the eletronic circuit (1) and/or the transducer elements (22, 30).

8. Measuring device according to any of the preceding claims, characterized in that said impedance device is formed by a transistor (4) modulating the current output from said semiconductor device.

9. Measuring device according to any of the preceding claims, characterized in that supply power is arranged to be taken out from the pn-junction (5) via a filter (2, 3), which reduces the effect of the modulation of the current output from the pn-junction (5) on the supply voltage.

10. Measuring device according to any of the preceding claims, characterized in that in addition to the material (19), the luminescence of which can be controlled, there is also another material (31) with photo-luminescence, which emits light at another wavelength than the material (19) and therefore can serve as a reference signal.

11. Measuring device according to claim 10, characterized in that the material (31, 41), which gives a reference signal in the form of photo-luminescence, is surrounded by a material with larger band gap (40, 42), the excited charge carriers thus being contained.

12. Measuring device according to any of the preceding claims, where the measured quantity is a parameter other than the temperature, characterized in that the wavelength displacement of the spectral distribution of the signal-transmitting light is arranged to be analyzed to obtain a value of the temperature, and that the temperature dependence on the measuring transducer is arranged to be corrected by means of the measured value of the temperature.

13. Measuring device according to any of the preceding claims, characterized in that the structure, which gives the light for the signal transmission, is partially transparent to the excitation light so that several structures can be placed one after the other in a bus structure along the optical path, and that the different structures can emit light of the same or of different wavelength and thus enable a wavelength-multiplexed transmission of the measuring signals.

14. Measuring device according to claim 1, characterized in that the transducer element consists of one or more components, the frequency properties of which are changed by the quantity to be measured, and that the frequency properties are arranged to be analyzed by measurement with several frequencies $(f_1, f_2)$, measurement of phase shift, time delay and/or time constant, to extract the measuring signal and compensate for variations of the parameters of the optical transmission.

15. Measuring device according to claim 7, characterized in that the transducer element comprises a resistor (30) representing said impedance device and varying in accordance to the variations of the quantity to be measured in such a way that the measuring signal is transmitted in analog form as a modulation of the light intensity.

16. Measuring device according to claim 15 and 10, characterized in that the measuring signal and the reference signal are arranged to be separated by optical filters (33, 34), and that the measuring signal is arranged to be compensated for variations of the parameters of the optical transmission, *either* by introducing variable amplifiers (45, 46) into the measuring or reference signal transmission, in which case a regulating loop (46—48) maintains the reference signal and thus the optical transmission constant, *or* by forming the quotient (39) between the measuring signal and the reference signal.

17. Measuring device according to claim 2, characterized in that the semiconductor material is $Al_xGa_{1-x}As$, where x assumes values between 0 and 1.

18. Measuring device according to claim 17, characterized in that the layer of the structure where the recombination takes place is doped with Ge, or Si, or Zn, or Mg, or Cd.

19. Measuring device according to claim 2, characterized in that the semiconductor material is $In_xGa_{1-x}As_yP_{1-y}$, x and y assuming values between 0 and 1 and being adapted such that the lattice constants for the measured value in the different layers are as equal as possible.

20. Measuring device according to claim 10, characterized in that the "reference material" is a so-called up-convertor.

21. Measuring device according to claim 11, characterized in that one of the materials, which limits the reference signal-providing material, is simultaneously included in the photo-luminescence diode.

## Revendications

1. Dispositif de mesure à fibre optique comportant une section de transducteur (1—5) qui comprend un circuit électronique alimenté de façon optique (1) et/ou des éléments transducteurs (22, 30) qui nécessitent de l'énergie d'excitation, l'alimentation et l'énergie d'excitation étant transmises sur la même fibre guide de lumière que l'information de signal (signal de mesure), grâce à quoi l'information de signal peut être émise vers un emplacement de récepteur sous la forme de lumière que est émise par la section de transducteur (1—5) lorsque des porteurs de charge excités de façon optique se recombinent à l'intérieur de la matière d'un dispositif semiconducteur photoluminescent dans la section de transducteur, et cette recombinaison peut être commandée conformément au signal d'information à émettre par la section de transducteur, caractérisé en ce qu'un dispositif à impédance variable (4, 22, 30) est connecté directement et en permanence aux bornes du dispositif semiconducteur (5), en ce que la valeur de ce dispositif à impédance varie conformément aux variations de la quantité à mesurer, et en ce que les variations du dispositif à impédance modulent de façon correspondante la lumière émise par le dispositif semiconducteur.

2. Dispositif de mesure selon la revendication 1, caractérisé en ce que la recombinaison, qui produit la lumière de signal, dépend de la concentration de porteurs de charge minoritaires dans une matière semiconductrice, en ce que cette matière est contenu dans une jonction pn (5), par exemple une diode, dans laquelle la bande interdite peut être égale (homostructure) ou différente (hétérostructure) pour la matière du côté p et du côté n, et en ce que la concentration de porteurs de charge minoritaires peut être commandée par le courant traversant la jonction pn (5), ou par le tension de part et d'autre de cette jonction.

3. Dispositif de mesure selon la revendication 1, caractérisé en ce que la recombinaison, qui produit la lumière de signal, dépend de la concentration de porteurs de charge minoritaires dans la matière semiconductrice, en ce que cette matière est contenue dans une diode Schottky ou dans une structure MIS, et en ce que la concentration de porteurs de charge minoritaires peut être commandée par le courant traversant la diode Schottky ou la structure MIS (5), ou par la tension appliquée de part et d'autre de cet élément.

4. Dispositif de mesure selon la revendication 1, caractérisé en ce que la recombinaison se produit dans une matière ayant une bande interdite décroissant de façon monotone le long du chemin de la lumière d'excitation, en ce que cette matière comporte une barrière, une jonction pn ou une structure Schottky ou MIS, produisant une couche de déplétion dont la position est déterminée par la tension appliquée de part et d'autre de la barrière, de la jonction pn ou de la structure Schottky ou MIS, et en ce que la lumière d'excitation a une longueur d'onde telle qu'une partir considérable de l'excitation des porteurs de charge se produit sur une distance correspondant à quelques longueurs de diffusion à partir du bord de la couche de déplétion, la distribution spectrale de la lumière émise dépendant ainsi de la tension appliquée à la barrière.

5. Dispositif de mesure selon la revendication 2 ou 3, caractérisé en ce que la matière (19) dans laquelle la lumière pour la transmission de signal est émise est limitée d'un côté par une matière (18, 20) ayant une plus grande bande interdite, ce qui empêche des porteurs de charge minoritaires excités d'atteindre des surfaces du semiconducteur avec une vitesse de recombinaison élevée.

6. Dispositif de mesure selon la revendication 2 ou 3, caractérisé en ce que la matière dans laquelle la lumière pour la transmission de signal est émise, comporte des deux côtés des barrières, des jonctions pn ou des structures Schottky ou MIS, pour moduler la concentration de porteurs de charge.

7. Dispositif de mesure selon l'une quelconque des revendications précédentes, caractérisé en ce que la partie du courant généré de façon optique qui traverse la barrière est utilisée pour alimenter le circuit électronique (1) et/ou les éléments transducteurs (22, 30).

8. Dispositif de mesure selon l'une quelconque des revendications précédentes, caractérisé en ce que le dispositif à impédance est formé par un transistor (4) qui module le courant de sortie du dispositif semiconducteur.

9. Dispositif de mesure selon l'une quelconque des revendications précédentes, caractérisé en ce que l'énergie d'alimentation est obtenu à partir de la jonction pn (5), par l'intermédiaire d'un filtre (2, 3) qui réduit l'effet de la modulation du courant de sortie de la jonction pn (5) sur la tension d'alimentation.

10. Dispositif de mesure selon l'une quelconque des revendications précédentes, caractérisé en ce que, en plus de la matière (19) dont on peut commander la luminescence, il existe également une autre matière photoluminescente (31), qui émet de la lumière à une longueur d'onde autre que celle de la matière mentionnée en premier (19) et qu'on peut donc utiliser en tant que signal de référence.

11. Dispositif de mesure selon la revendication 10, caractérisé en ce que la matière (31, 41) qui produit un signal de référence sous la forme de lumière de photoluminescence, est entourée par une matière ayant une plus grande bande interdite (40, 42), ce qui a pour effet de confiner les porteurs de charge excités.

12. Dispositif de mesure selon l'une quelconque des revendications précédentes, dans lequel la quantité mesurée est un paramètre autre que la température, caractérisé en ce qu'on peut analyser le déplacement de longueur d'onde dans la distribution spectrale de la lumière de transmission de signal, pour obtenir une valeur de la température, et en ce qu'on peut corriger la dépendance du transducteur de mesure vis-à-vis de la température, au moyen de la valeur mesurée de la température.

13. Dispositif de mesure selon l'une quelconque des revendications précédentes, caractérisé en ce que la structure qui produit la lumière pour la transmission de signal est partiellement transparente à la lumière d'excitation, ce qui fait qu'on peut placer plusieurs structures l'une après l'autre dans une structure de bus le long du chemin optique, et en ce que les différentes structures peuvent émettre de la lumière ayant la même longueur d'onde ou des longueurs d'onde différentes et permettent ainsi une transmission des signaux de mesure avec multiplexage en longueur d'onde.

14. Dispositif de mesure selon la revendication 1, caractérisé en ce que l'élément transducteur consiste en un ou plusieurs composants dont les propriétés fréquentielles sont modifiées par la quantité à mesurer, et en ce qu'on analyse les propriétés fréquentielles par la mesure, à plusieurs fréquences $(f_1, f_2)$, d'un déphasage, d'un retard et/ou d'une constante de temps, pour extraire le signal de mesure et pour compenser des variations des paramètres de la transmission optique.

15. Dispositif de mesure selon la revendication 7, caractérisé en ce que l'élément transducteur comprend une résistance (30) qui représente le dispositif à impédance et qui varie conformément aux variations de la quantité à mesurer, d'une manière telle que le signal de mesure soit transmis sous forme analogique, en tant que modulation de l'intensité de la lumière.

16. Dispositif de mesure selon les revendications 15 et 10, caractérisé en ce que le signal de mesure et le signal de référence sont séparés par des filtres optiques (33, 34), et en ce que le signal de mesure est compensé vis-à-vis de variation des paramètres de la transmission optique, *soit* par l'introduction d'amplificateurs variables (45, 46) dans la transmission du signal de mesure ou de référence, auquel cas une boucle de régulation (46—48) maintient constants le signal de référence et dont la transmission optique, *soit* par la formation du quotient (39) entre le signal de mesure et le signal de référence.

17. Dispositif de mesure selon la revendication 2, caractérisé en ce que la matière semi-conductrice consiste en $Al_xGa_{1-x}As$, avec pour x des valeurs comprises entre 0 et 1.

18, Dispositif de mesure selon la revendication 17, caractérisé en ce que la couche de la structure dans laquelle la recombinaison se produit est dopée avec Ge ou Si ou Zn ou Mg ou Cd.

19. Dispositif de mesure selon la revendication 2, caractérisé en ce que la matière semi-conductrice consiste en $In_xGa_{1-x}As_yP_{1-y}$, avec pour x et y des valeurs comprises entre 0 et 1, et est conçue de façon que les constantes de réseau pour la valeur mesurée dans les différentes couches soient aussi égales que possible.

20. Dispositif de mesure selon la revendication 10, caractérisé en ce que la "matière de référence" est ce qu'on appelle on convertisseur élévateur.

21. Dispositif de mesure selon la revendication 11, caractérisé en ce que l'une des matières, qui limite la matière produisant le signal de référence, est simultanément contenue dans la diode photoluminescente.

**Patentansprüche**

1. Faseroptisches Meßgerät mit einem Signalwandlerteil (1 bis 5), welches ein optisch gespeistes elektronisches Glied (1) und/oder Signalwandlerelemente (20, 30) enthält, die eine Erregungsenergie benötigen, wobei die Versorgungsleistung und die Erregungsenergie über dieselbe lichtübertragende Faser übertragen werden wie die Signalinformation (Meßsignal), wobei die genannten Signalinformation an den Empfangsort in Form von Licht übertragen wird, welches von dem Signalwandlerteil (1 bis 5) ausgestrahlt wird, wenn optisch erregte Ladungsträger in dem Material eines fotolumineszierenden Halbleiterbauteils des Signalwandlerteils rekombinieren, und wobei diese Rekombination in Abhängigkeit des von dem Signalwandlerteil auszusendenden Informationssignals gesteuert wird, dadurch gekennzeichnet, daß ein variierbares Impedanzelement (4, 22, 30) direkt und ständig beidseitig an das Halbleiterelement (5) geschaltet ist, daß der Wert dieses Impedanzelements sich mit den Änderungen der zu messenden Größe verändert und daß die Änderungen diese Impedanzelements das Ausgangslicht des genannten Halbleiterelements entsprechend modulieren.

2. Meßgerät nach Anspruch 1, dadurch gekennzeichnet, daß die das Signallicht verursachenden Rekombination von der Konzentration der Minoritätladungsträger im Halbleitermaterial abhängig ist, daß sich das Material in einem pn-Übergang (5), zum Beispiel einer Diode, befindet, in welchem die Bandabstand für das Material auf der p- und der n-Seite gleich (Homostruktur) oder unterschiedlich (Heterostruktur) sein hann, und daß die Konzentration an Minoritätladungsträger entweder von dem Strom durch oder die Spannung an dem pn-Übergang (5) gesteuert wird.

3. Meßgerät nach Anspruch 1, dadurch gekennzeichnet, daß die Rekombination, welche das Signallicht verursacht, von der Konzentration der Minoritätladungsträger in dem Halbleitermaterial abhänigig ist, daß sich das Material in einer Schottky-Diode oder einer MIS-Struktur befindet und daß die Konzentration der Minoritätladungsträger von dem Strom durch oder der Spannung an der Schottky-Diode oder der MIS-Struktur (5) gesteuert wird.

4. Meßgerät nach Anspruch 1, dadurch gekennzeichnet, daß die Rekombination in einem Material mit monoton abnehmendem Bandabstand längs des Pfades des Anregungslichtes stattfinder, daß das Material mit einer Sperrschicht, einem pn-Übergang, Schottky- oder einer MIS-Struktur versehen ist, die eine Verarmungszone hat, deren Lage von der Spannung an der genannten Sperrschicht, dem pn-Übergang, der Schottky- oder der MIS-Struktur bestimmt wird, und daß das Anregungslicht eine solche Wellenlänge hat, daß ein beträchtlicher Anteil der Erzeugung von Ladungsträgern innerhalb eines Abstandes von einigen Diffusionslängen von der Kante der Verarmungszone stattfindet, so daß die spektrale Verteilung des emiitierten Lichtes von der Spannung an der Sperrschicht abhängig wird.

5. Meßgerät nach einem der Ansprüche 2 oder 3, dadurch gekennzeichnet, daß das Material (19), welches das Licht für die Signalübertragung emiitiert, an einer Seite von einem Material (18, 20) mit einem größeren Bandabstand begrenzt wird, wodurch die erzeugten Minoritätladungsträger daran gehindert werden, die Halbleiteroberflächen mit einer hohen Rekombinationsgeschwindigkeit zu erreichen.

6. Meßgerät nach einem der Ansprüche 2 oder 3, dadurch gekennzeichnet, daß das Material, aus welchem das Licht für die Signalübertragung emiitiert wird, an beiden Seiten mit Sperrschichten, pn-Übergängen, Schottky- oder MIS-Strukturen zur Modulation der Ladungsträgerkonzentration versehen sind.

7. Meßgerät nach einem der vorhergehenden Ansprüche, dadurch gekennzeichnet, daß ein Teil des optisch erzeugten Stromes durch die Sperrschicht angepaßt wird, um als Versorgungsenergie für das elektronische Glied (1) und/oder die Signalwandlerelemente (20, 30) zu dienen.

8. Meßgerät nach einem der vorhergehenden Ansprüche, dadurch gekennzeichnet, daß das genannte Impedanzelement eine Transistor (4) ist, welcher den Ausgangsstrom dieses Halbleiterelements moduliert.

9. Meßgerät nach einem der vorhergehenden Ansprüche, dadurch gekennzeichnet, daß die Versorgungsleistung von dem pn-Übergang (5) über ein Filter (2, 3) entnommen wird, welches die Wirkung der Modulation des Stromausganges des pn-Überganges (5) auf die Versorgungsspannung reduziert.

10. Meßgerät nach einem der vorhergehenden Ansprüche, dadurch gekennzeinet, daß zusätzlich zu dem Material (19), dessen Lumineszens steuerbar ist, ein weiteres fotolumineszierendes Material (31) vorhanden ist, welches Licht mit einer anderen Wellenlänge emittiert als das Material (19) und welches daher als Bezugssignal dienen kann.

11. Meßgerät nach Anspruch 10, dadurch gekennzeichnet, daß das Material (31, 41), welches ein auf Fotolumineszens beruhendes Bezugssignal liefert, von einem Material mit einem größeren Bandabstand (40, 42) umgeben ist, wodurch die erzeugten Ladungsträger eingeschlossen werden.

12. Meßgerät nach einem der vorhergehenden Ansprüche, bei welchem die gemessene Größe ein andere Parameter als die Temperatur ist, dadurch gekennzeichnet, daß die Wellenlängenverschiebung in der spektralen Verteilung des signalübertragenden Lichtes analysiert wird, um einen Temperaturwert zu erhalten, und daß die Temperaturabhängigkeit des Meßwertwandlers in Abhängigkeit des gemessenen Temperaturwertes korrigiert wird.

13. Meßgerät nach einem der vorhergehenden Ansprüche, dadurch gekennzeichnet, daß die Struktur, welche das Licht für die Signalübertragung liefert, derart teilweise für das Anregungslicht durchlässig ist, daß mehrere Strukturen längs des optischen Pfades hintereinander in einer Vielfachstruktur (bus-structures angeordnet werden können, und daß die verschiedenen Strukturen Licht derselben Wellenlänge oder unterschiedlicher Wellenlänge emittieren können, wodurch eine wellenlängenmultiplxierte Übertragung der Meßsignale ermöglicht wird.

14. Meßgerät nach Anspruch 1, dadurch gekennzeichnet, daß das Signalwandlerelement aus einer oder mehreren Komponenten besteht, deren Frequenzeigenschaften durch die zu messende Größe verändert werden, und daß die Frequenzeigenschaften durch eine Messung mit mehreren Frequenzen ($f_1$, $f_2$), einer Messung der Phasenverschiebung, der Zeitverzögerung und/oder der Zeitkonstanten analysiert werden, um das Meßsignal zu gewinnen und um in Bezug auf Veränderungen der Parameter der optischen Übertragungseinrichtung eine Kompensation vorzunehmen.

15. Meßgerät nach Anspruch 7, dadurch gekennzeichnet, daß das Signalwandlerelement einen Widerstand (30) enthält, welcher das genannte Impedanzelement darstellt und sich entsprechend den Änderungen der Meßgröße derart verändert, daß das Meßsignal in analoger Form als Modulation der Lichtstärke übertragen wird.

16. Meßgerät nach Anspruch 15 und 10, dadurch gekennzeichnet, daß das Meßsignal und das Bezugssignal durch optische Filter (33, 34) voneinander getrennt werden, daß das Meßsignal in Bezug auf Veränderungen der Parameter der optischen Übertragungseinrichtung kompensiert wird, und zwar entweder durch Einführung verstellbarer Verstärker (45, 46) in den Übertragungsweg des Meß- oder Bezugssignals, in welchem Falle ein geschlossenen Regelkreis (46 bis 48) das Bezugssignal aufrechterhält und damit die optische Übertragung konstant hält, oder durch Bildung des Quotienten (39) aus dem Meßsignal und dem Bezugssignal.

17. Meßgerät nach Anspruch 2, dadurch gekennzeichnet, daß das Halbleitermaterial aus $Al_xGa_{1-x}As$ besteht, wobei x Werte zwischen 0 und 1 annimmt.

18. Meßgerät nach Anspruch 17, dadurch gekennzeichnet, daß die Schicht der Struktur, in der die Rekombination stattfindet, mit Ge, oder Si, oder Zn, oder Mg, oder Cd dotiert ist.

19. Meßgerät nach Anspruch 2, dadurch gekennzeichnet, daß das Halbleitermaterial aus $In_xGa_{1-x}As_yP_{1-y}$ besteht, wobei x und y Werte zwischen 0 und 1 annehmen und derart angepaßt ist, daß die Gitterkonstanten für den Meßwert in den verschiedenen Schichten möglichst gleich sind.

20. Meßgerät nach Anspruch 10, dadurch gekennzeichnet, daß das "Bezugsmaterial" ein sogenannter Aufwärtswandler ist.

21. Meßgerät nach Anspruch 11, dadurch gekennzeichnet, daß eines der Materialien, welcher das das Bezugssignal erzeugende Material begrenzt, gleichzeitig in der fotolumineszierenden Diode enthalten ist.

FIG. 1

FIG. 2

FIG. 3

FIG. 4

FIG.5

# 0 043 929

**FIG.6**

**FIG. 7**

FIG. 8

FIG.9

FIG. 10

FIG. 11